# EUROPEAN PATENT APPLICATION

(11) **EP 3 422 639 A2**
(43) Date of publication of application: **02.01.2019**
(21) Application number: 18179545.1
(22) Date of filing: 25.06.2018
(51) Int. Cl.: H04L 12/26, H04L 12/24

(54) **PERFORMANCE TESTING METHOD AND APPARATUS FOR AN INDUSTRIAL SYSTEM DEPLOYED ON CLOUD**

(30) Priority: 30.06.2017 CN 201710525137
(71) Applicant: Siemens Aktiengesellschaft, 80333 München (DE)
(72) Inventor: MAO, Yi, Beijing, 100102 (CN)
(74) Representative: Isarpatent

(57) **Abstract**

The present invention provides a performance testing method and apparatus and a computer readable medium, used for performing performance testing on an industrial system deployed on a cloud. The method comprises: monitoring measurement items (S501), such as end-to-end delay, network throughput, network delay, CPU usage, memory usage and the like; according to the measurement items obtained by monitoring, determining the performance of the industrial system, and generating measurement results (S502); and displaying the measurement results to a user (S503). If the industrial system is a simulated industrial system, the method may also comprise: configuring the industrial system (S504) and cloud resources for running the industrial system (S505), and running the industrial system on the configured cloud resources (S506). The measurement results accurately reflect the overall performance of the industrial system. The simulated industrial system and cloud resources thereof may be configured flexibly so as to accurately measure the performance of the industrial system before the industrial system is established, thereby providing references for the running of the industrial system and the distribution of cloud resources afterwards.

## Description

### BACKGROUND

### Technical Field

The present invention relates to the technical field of performance testing, and particularly to a performance testing method and apparatus for an industrial system deployed on a cloud.

### Related Art

Currently, the cloud computing technology has been widely used in an enterprise's information technology (IT) system, but an operational technology (OT) system is still implemented based on hardware in a proprietary factory in most cases. When a traditional OT system software provider or customer considers deploying an OT system to a cloud, they may be concerned about the performance of the OT system deployed on the cloud and whether it meets the requirements of an actual application scenario.

By taking an industrial system-supervisory control and data acquisition (SCADA) system as an example, when performance testing is performed on the system in the past, only one single device, such as an SCADA server, in the system is tested generally. Test items generally comprise CPU usage, memory usage, and the like. These test results can only reflect the performance of one single device, but can not reflect the performance of the entire system.

### SUMMARY

The embodiments of the present invention provide a performance testing solution used for performing performance testing on an industrial system deployed on a cloud, wherein the test results can reflect the performance of the entire industrial system.

Besides, the embodiments of the present invention also provides another performance testing solution used for performing performance testing on a simulated industrial system deployed on a cloud. A real industrial system is simulated by performing parameter configuration on the simulated industrial system. Before a real industrial system is established, the performance of the industrial system on the cloud is learned so as to provide references for the running of the industrial system and the distribution of cloud resources afterwards.

In the first aspect, the present invention provides a performance testing method used for performing performance testing on an industrial system deployed on a cloud. The method comprises the following steps: acquiring a device processing delay of each device in at least two devices on an end-to-end processing path in the industrial system and a data transmission delay between any two adjacent devices in the at least two devices; and determining an end-to-end delay on the processing path according to the device processing delay and the data transmission delay acquired to measure the performance of the industrial system.

An industrial system is generally required to have real-time control, so a delay is an important indicator for measuring the performance of an industrial system. After a traditional industrial system is deployed onto the cloud, not only a processing delay of the device, but also a data transmission delay needs to be considered. Therefore, in the embodiments of the present invention, an end-to-end delay is regarded as an important measurement item for measuring the performance of the industrial system deployed on the cloud, and the measurement results can more accurately reflect the overall performance of the industrial system.

Optionally, the method further comprises: determining an end-to-end delay on at least one other processing path in the industrial system; and comparing the acquired end-to-end delays on the various processing paths to determine a device and/or transmission line affecting the performance of the industrial system.

Because the end-to-end delay on each processing path can be obtained, the performance of the industrial system can be subjected to piecewise analysis, and then targeted analysis is performed according to the results of the piecewise analysis, so as to effectively improve the system performance.

Optionally, the industrial system is a simulated industrial system, and before acquiring the device processing delay of each device in at least two devices on an end-to-end processing path in the industrial system and the data transmission delay between any two adjacent devices in the at least two devices, the method further comprises: receiving user configuration of the industrial system; and running the configured industrial system.

Before a real industrial system is established, in order to learn the performance of the industrial system on the cloud so as to provide references for the running of the industrial system and the distribution of cloud resources afterwards, an industrial system deployed on the cloud is simulated by configuring configuration parameters of an industrial system, and the simulated industrial system is tested so as to accurately measure the performance of the industrial system before the industrial system is established, thereby providing references for the running of the industrial system and the distribution of cloud resources afterwards.

Optionally, the receiving user configuration of the industrial system comprises: receiving and configuring at least one of the following parameters of the industrial system input by the user: scenarios of the industrial system; communication protocols used by the industrial system; security algorithms used by the industrial system; and loads of the industrial system.

In this way, the user can perform parameter configuration according to actual conditions of the industrial system to be tested, and the results of performance testing are closer to the actual conditions and more referential.

Optionally, before the running the simulated industrial system, the method further comprises: receiving user configuration of cloud resources for running the simulated industrial system; and the running the configured industrial system comprises: running the industrial system on the configured cloud resources.

The performance of an industrial system under a specific cloud resource configuration can be obtained. The performance of the industrial system under different cloud resource configurations can also be obtained, and the optimal cloud resource configuration is obtained by comparison.

Optionally, the receiving user configuration of the industrial system comprises: receiving the industrial system configured by at least one user through a Web user interface (UI); and/or displaying performance of the industrial system to the at least one user through the Web UI.

This provides convenience for the user to configure the industrial system and observe the performance of the industrial system.

In the second aspect, the present invention provides a performance testing method used for performing performance testing on an industrial system deployed on a cloud, wherein the industrial system is a simulated industrial system, and the method comprises: receiving and configuring at least one of the following parameters of the industrial system input by a user: scenarios of the industrial system; communication protocols used by the industrial system; security algorithms used by the industrial system; and loads of the industrial system; running the configured industrial system; and performing performance testing on the industrial system.

Before a real industrial system is established, in order to learn the performance of the industrial system on the cloud so as to provide references for the running of the industrial system and the distribution of cloud resources afterwards, an industrial system deployed on the cloud is simulated by configuring configuration parameters of an industrial system, and the simulated industrial system is tested so as to accurately measure the performance of the industrial system before the industrial system is established, thereby providing references for the running of the industrial system and the distribution of cloud resources afterwards. Thus, the user can perform parameter configuration according to actual conditions of the industrial system to be tested, and the results of performance testing are closer to the actual conditions and more referential.

Optionally, before running the industrial system, the method further comprises: receiving user configuration of cloud resources for running the industrial system; and the running the configured industrial system comprises: running the industrial system on the configured cloud resources.

The performance of an industrial system under a specific cloud resource configuration can be obtained. The performance of the industrial system under different cloud resource configurations can also be obtained, and the optimal cloud resource configuration is obtained by comparison.

Optionally, the performing performance testing on the industrial system comprises: acquiring a device processing delay of each device in at least two devices on an end-to-end processing path in the industrial system and a data transmission delay between any two adjacent devices in the at least two devices; and determining an end-to-end delay on the processing path according to the device processing delay and the data transmission delay acquired to measure the performance of the industrial system.

An industrial system is generally required to have real-time control, so a delay is an important indicator for measuring the performance of an industrial system. After a traditional industrial system is deployed onto the cloud, not only a processing delay of the device, but also a data transmission delay needs to be considered. Therefore, in the embodiments of the present invention, an end-to-end delay is regarded as an important measurement item for measuring the performance of the industrial system deployed on the cloud, and the measurement results can more accurately reflect the overall performance of the industrial system.

Optionally, the performing performance testing on the industrial system further comprises: determining an end-to-end delay on at least one other processing path in the industrial system; and the method further comprises: comparing the acquired end-to-end delays on the various processing paths to determine a device and/or transmission line affecting the performance of the industrial system.

Because the end-to-end delay on each processing path can be obtained, the performance of the industrial system can be subjected to piecewise analysis, and then targeted analysis is performed according to the results of the piecewise analysis, so as to effectively improve the system performance.

In the third aspect, the present invention provides a performance testing apparatus used for performing performance testing on an industrial system deployed on a cloud. The apparatus can be used for executing the testing method provided by the first aspect. The apparatus comprises: a measurement module, used for acquiring a device processing delay of each device in at least two devices on an end-to-end processing path in the industrial system and a data transmission delay between any two adjacent devices in the at least two devices; and a performance determination module, used for determining an end-to-end delay on the processing path according to the device processing delay and the data transmission delay acquired by the measurement module to measure the performance of the industrial system.

An industrial system is generally required to have real-time control, so a delay is an important indicator for measuring the performance of an industrial system. After a traditional industrial system is deployed onto the cloud, not only a processing delay of the device, but also a data transmission delay needs to be considered. Therefore, in the embodiments of the present invention, an end-to-end delay is regarded as an important measurement item for measuring the performance of the industrial system deployed on the cloud, and the measurement results can more accurately reflect the overall performance of the industrial system.

In the fourth aspect, the present invention provides a performance testing apparatus used for performing performance testing on an industrial system deployed on a cloud, wherein the industrial system is a simulated industrial system. The apparatus can be used for executing the method provided by the second aspect. The apparatus comprises: a configuration module, used for receiving and configuring at least one of the following parameters of the industrial system input by a user: scenarios of the industrial system; communication protocols used by the industrial system; encryption algorithms used by the industrial system; and loads of the industrial system; wherein the configuration module is also used for running the configured industrial system on the cloud; and a performance testing module, used for performing performance testing on the industrial system.

Before a real industrial system is established, in order to learn the performance of the industrial system on the cloud so as to provide references for the running of the industrial system and the distribution of cloud resources afterwards, an industrial system deployed on the cloud is simulated by configuring configuration parameters of an industrial system, and the simulated industrial system is tested so as to accurately measure the performance of the industrial system before the industrial system is established, thereby providing references for the running of the industrial system and the distribution of cloud resources afterwards.

In the fifth aspect, the present invention provides a performance testing apparatus which comprises: at least one memory, used for storing a computer readable instruction; and at least one processor, used for calling the computer readable instruction to execute the method provided by the first aspect, any possible implementation manner of the first aspect, the second aspect or any possible implementation manner of the second aspect.

In the sixth aspect, the present invention provides a computer readable medium, wherein the computer readable medium stores a computer readable instruction, and the machine readable instruction, when being executed by at least one processor, enables the at least one processor to execute the method provided by the first aspect, any possible implementation manner of the first aspect, the second aspect or any possible implementation manner of the second aspect.

### BRIEF DESCRIPTION OF THE DRAWINGS

FIG. 1 is a structure diagram of an SCADA system.
FIG. 2A is a structure diagram of a performance testing apparatus provided by the embodiments of the present invention.
FIG. 2B is a structure diagram of a performance testing apparatus provided by the embodiments of the present invention when a real industrial system is tested.
FIG. 2C is a structure diagram of a performance testing apparatus provided by the embodiments of the present invention when a simulated industrial system is tested.
FIG. 2D is a structure diagram of a performance testing apparatus provided by the embodiments of the present invention when a simulated industrial system is tested.
FIG. 3 is a diagram of an end-to-end delay in the embodiments of the present invention.
FIG. 4A to FIG. 4E are diagrams of various scenarios of an industrial system in the embodiments of the present invention.
FIG. 5 is a flow chart of a performance testing method provided by the embodiments of the present invention.
FIG. 6 is a structure diagram of another performance testing apparatus provided by the embodiments of the present invention.
FIG. 7A and FIG. 7B are test results obtained by performing performance testing on an industrial system by using the embodiments of the present invention.

**List of reference signs:**

| | | |
|---|---|---|
| 10: SCADA System | 100: Central Location | 200: Industrial Field |
| 101: SCADA Server | 102: RTU | 103: Field Device |
| 104: HMI | 105 : ERP System | 201: Performance Testing Module |
| 202: User Interface Module | 20: Performance Testing Apparatus | 2011: Measurement Module |
| 2012: Performance Determination Module | 203: Configuration Module | 2021: Configuration Interface |
| 2022: Result Display Interface | 2031: Program Interface Module | 2032: Cloud Service Management Module |
| 2033: Open Library | 2034: Database | 2034a: Configuration File |
| 2034b: Mirror Image File | 30: Cloud | 2011a: Monitoring Module |
| 2011b: Log Shipping Module | 2011c: Log Integration Module | 2011d: Measurement Item Generation Module |
| 2011e: Lookup And Storage Module | S501: Monitor measurement items | S502: Generate measurement results |
| S503: Display the measurement results | S504: Configure an industrial system | S505: Configure cloud resources |
| S506: Run the industrial system | 601: At Least One Memory | 602: At Least One Processor |
| 603: Touch Screen | | |

### DETAILED DESCRIPTION

On one hand, as mentioned before, there is currently no method for testing the overall performance of an industrial system deployed on the cloud. An industrial system is generally required to have real-time control, so a delay is an important indicator for measuring the performance of an industrial system. After a traditional industrial system is deployed onto the cloud, not only a processing delay of the device, but also a data transmission delay needs to be considered. Therefore, in the embodiments of the present invention, an end-to-end delay is regarded as an important measurement item for measuring the performance of the industrial system deployed on the cloud, and the measurement results can more accurately reflect the overall performance of the industrial system.

On the other hand, before a real industrial system is established, in order to learn the performance of the industrial system on the cloud so as to provide references for the running of the industrial system and the distribution of cloud resources afterwards, in the embodiments of the present invention, an industrial system deployed on the cloud is simulated by configuring configuration parameters of an industrial system, and the simulated industrial system is tested so as to accurately measure the performance of the industrial system before the industrial system is established, thereby providing references for the running of the industrial system and the distribution of cloud resources afterwards.

In the embodiments of the present invention, an SCADA system is described as an example of the industrial system. The embodiments of the present invention may be used for testing the performance of an SCADA system. It should be noted that the embodiments of the present invention may also be used for testing other types of industrial systems, such as SCADA system SIMATIC WinCC open architecture (WinCC OA) and the like. The embodiments of the present invention may be specifically used for testing the performance of software running on an industrial system. Industrial fields involved with industrial systems that can be tested by the embodiments of the present invention comprise wind power generation, automobile manufacturing, pharmaceuticals, sewage treatment, building control, and the like.

The embodiments of the present invention will be described in detail below with reference to the accompanying drawings.

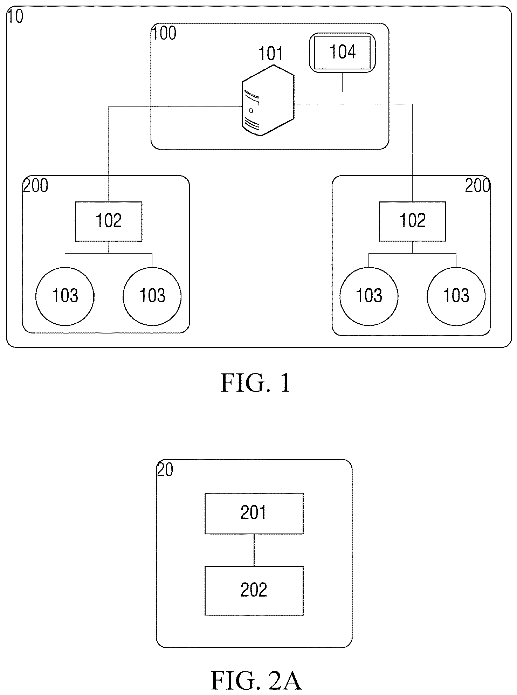

In the embodiments of the present invention, an industrial system may comprise at least two devices. By taking an SCADA system 10 as shown in FIG. 1 as an example, the SCADA system 10 may comprise at least one SCADA server 101, at least one remote terminal unit (RTU) 102, at least one field device 103, at least one human machine interface (HMI) 104 and the like. A supervisory control and data acquisition (SCADA) system may be used in an industrial production process to perform industrial control and monitoring. An SCADA server 101 deployed at a central location 100 needs to communicate with a large number of field devices 103 located at an industrial field 200 to obtain field data. The field devices 103 may comprise a programmable logic controller (PLC), instruments and the like. Working personnel may monitor the industrial production process by using the HMI 104. The RTU 102 located at the industrial field 200 is used for implementing communication between the field devices 103 and the SCADA server 101.

FIG. 2A is a structure diagram of a performance testing apparatus 20 provided by the embodiments of the present invention. The performance testing apparatus 20 may be used for measuring the performance of an industrial system, such as an SCADA system 10 as shown in FIG. 1. As shown in FIG. 2A, the performance testing apparatus 20 may comprise:
a measurement module 2011, used for acquiring at least one measurement item for measuring the performance of an industrial system; and
a performance determination module 2012, used for determining the performance of the industrial system according to the at least one measurement item acquired by the measurement module 2011.

Traditional performance testing for an industrial system generally only considers the processor usage and/or memory usage of a single device, such as the memory usage and the processor usage of an SCADA server in an SCADA system. For example, when customers need to deploy an industrial system, they generally raise requirements for the load and performance, and the provider of the industrial system sets the system capacity to meet these complex performance requirements. A load test is generally performed before the system is delivered to test whether the system meets the requirements under normal load and high load conditions. However, the common performance testing only tests the performance of a single device, such as processor usage, and there is a lack of testing of the overall performance of a system, and no testing of the overall performance of an industrial system deployed on the cloud.

In the embodiments of the present invention, when an industrial system is tested, the overall performance of the system is taken into consideration, for example, using end-to-end delay, network throughput, network delay and other measurement items to measure the overall performance of the system. Specifically, in conjunction with the performance testing apparatus 20 shown in FIG. 2A, measurement items acquired by the measurement module 2011 comprise, but are not limited to, end-to-end delay, network throughput, network delay (i.e. delay caused by transmission of data on the line), processor usage and memory usage.

After an industrial system is deployed on the cloud, generally some devices will be deployed at the central location 100 as shown in FIG. 1, while other devices are deployed at the industrial field 200, so that the impact of the end-to-end delay on the industrial system becomes even more prominent.

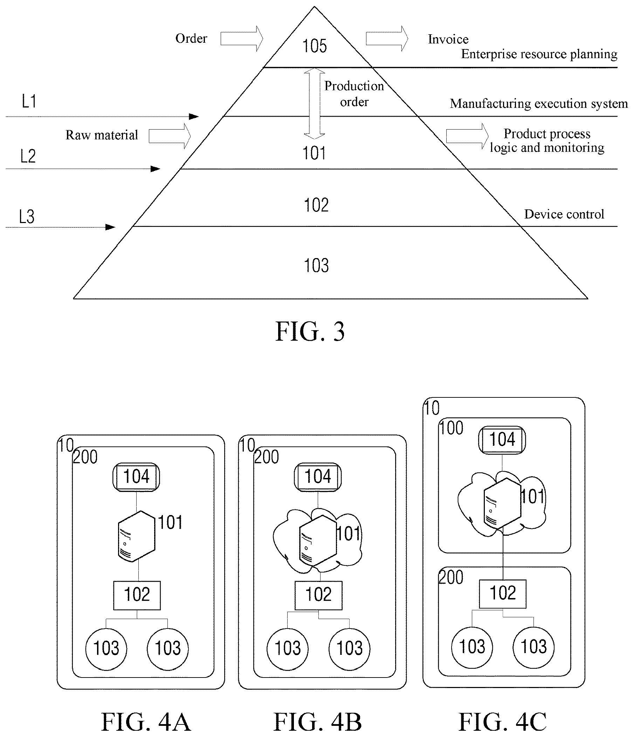

If not only considering the industrial production process but also considering receiving of customer orders and delivery to customers, an industrial system may have a hierarchical structure as shown as FIG. 3, comprising:

### 1) Enterprise Resource Planning (ERP) System 105

The ERP 105 is responsible for receiving orders from customers, and ultimately delivering them to the customers and providing invoices. After the ERP 105 receives an order from a customer, the order is submitted to an MES, and a production order is generated by the MES and sent to an automation layer.

### 2) Manufacturing Execution System (MES)

### 3) Automation Layer

By taking an SCADA system 10 as an example, the automation layer generally comprises at least one SCADA server 101 used for completing automated production to implement process logic and monitoring.

### 4) Device Controller

The device controller generally comprises at least one programmable logic controller (PLC), and by taking an SCADA system 10 as an example, the device controller may further comprise at least one RTU 102. The device controller is used for implementing device control and specific process logic.

### 5) Input/Output (I/O) Device

The I/O device generally comprises at least one field device 103, and completes a specific industrial production process under the control of the PLC or RTU.

Different layers have different end-to-end delays. For example, the end-to-end delay between the device controller and the I/O device is L1, the end-to-end delay between an automation layer device and the device controller is L2, and the end-to-end delay between the automation layer and the MES is L3; and generally, L3 is greater than L2, and L2 is greater than L1.

In the embodiments of the present invention, the end-to-end delay acquired during performance testing may refer to a delay between any two devices, for example, if the RTU 102 acquires field data from the field device 103 and sends the field data to the SCADA server 101, the time required from the receiving of the field data by the RTU 102 to the sending of the field data to the SCADA server 101 may be considered as an end-to-end delay.

If the measurement items comprise the end-to-end delay, then the measurement module 2011 may acquire a device processing delay of each device in at least two devices on an end-to-end processing path in an industrial system and a data transmission delay between any two adjacent devices in the at least two devices, and the performance determination module 2012 determines an end-to-end delay on the processing path according to the device processing delay and the data transmission delay acquired by the measurement module 2011 to measure the performance of the industrial system.

Optionally, the measurement module 2011 may acquire various measurement items by acquiring logs of devices in the industrial system, for example, the log of a device A may comprise a time t1 when a piece of data arrives at the device A, and a time t2 when the piece of data is sent out by the device A after being processed by the device A, and then t2-tl is the device processing delay that the device A processes the piece of data. When the piece of data is sent from the device A to a device B, the log of the device B may comprise a time t3 when the piece of data arrives at the device B, and then t3-t2 is the data transmission delay that the piece of data is transmitted from the device A to the device B. By acquiring logs from various devices to obtain the times when a piece of data arrives at and leaves a device, piecewise calculation of the end-to-end delay can be implemented, and by comparing end-to-end delays on different processing paths, the problems that affect the performance of the industrial system can be detected more easily, thereby providing references for the enhancement of the performance of the industrial system.

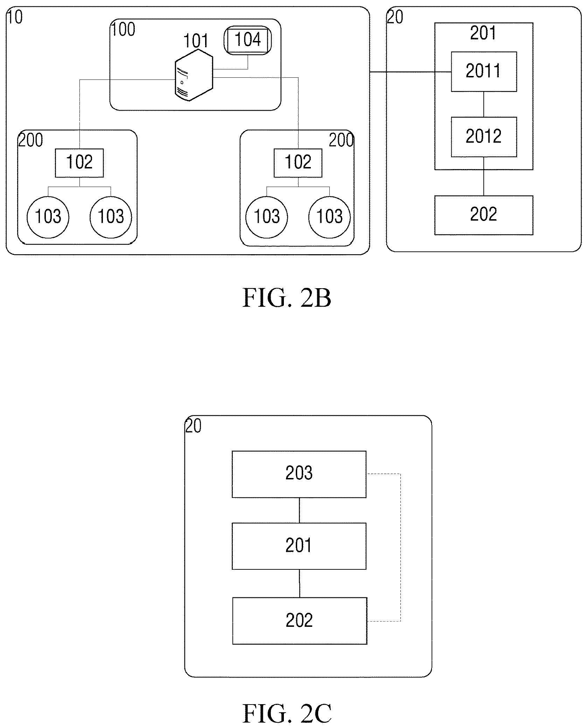

If the tested system is a real industrial system, then as shown in FIG. 2B, the measurement module 2011 may acquire a log of at least one device in an industrial system, such as the SCADA system 10, and determine an end-to-end delay on a processing path according to the various times recorded in the log. Besides, the forementioned network throughput, network delay, processor usage, memory usage and the like may also be determined by acquiring logs of various devices.

If the tested system is a simulated industrial system, then as shown in FIG. 2C, the performance testing apparatus 20 further comprises a configuration module 203, used for configuring at least one of the following parameters of the simulated industrial system:
1) scenarios of the industrial system;
2) communication protocols used by the industrial system;
3) security algorithms used by the industrial system; and
4) loads of the industrial system.

The above parameters are described one by one below:

### 1) Scenarios of the industrial system

Scenarios of an industrial system may comprise: a bare metal industrial system, a plant industrial system, a central industrial system, a distributed industrial system and a hierarchical industrial system. By taking the SCADA system 10 as an example, the scenarios of the industrial system may comprise: a bare metal SCADA system, a plant SCADA system, a central SCADA system, a distributed SCADA system, a hierarchical SCADA system and the like.

In the SCADA system 10 as shown in FIG. 4A, the SCADA server 101 is a hardware server that is not deployed on the cloud, and all the devices are located at the industrial field 200.

In the SCADA system 10 as shown in FIG. 4B, the SCADA server 101 is deployed on a private cloud, and all the devices are also located at the industrial field 200.

In the SCADA system 10 as shown in FIG. 4C, the SCADA server 101 is deployed on a public cloud or a private cloud, the SCADA server 101 and the HMI 104 are located at the central location 100, and the other devices are located at the industrial field 200.

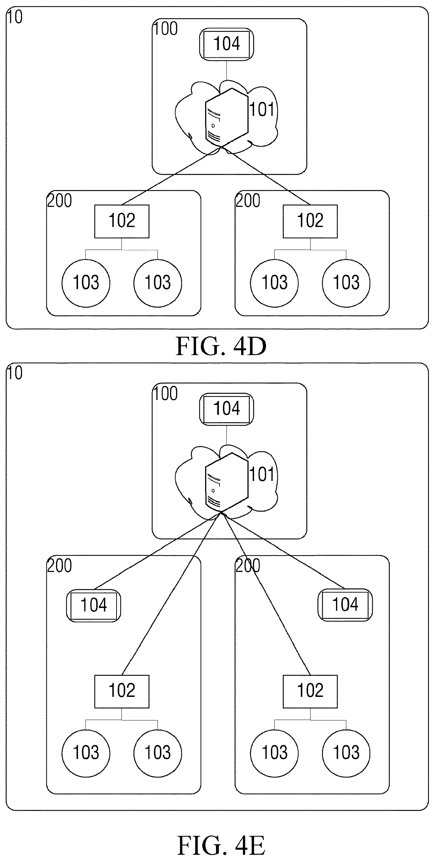

In the SCADA system 10 as shown in FIG. 4D, the SCADA server 101 is deployed on a public cloud or a private cloud, the SCADA server 101 and the HMI 104 are located at the central location 100, and the other devices are located at the industrial field 200, wherein one SCADA server 101 is connected with at least two RTUs 102, and optionally, one or more of the at least two RTUs 102 are deployed on the private cloud.

In the SCADA system 10 as shown in FIG. 4E, the SCADA server 101 is deployed on a public cloud or a private cloud, the SCADA server 101 and the HMI 104 are located at the central location 100, and the other devices are located at the industrial field 200, wherein one SCADA server 101 is connected with at least two RTUs 102, and optionally, one or more of the at least two RTUs 102 are deployed on the private cloud. At least one industrial field has the HMI 104, and the HMI 104 is connected with the SCADA server 101.

### 2) Communication protocols used by the industrial system

For example, Modbus TCP/IEC 870-5-101 (Modbus Transmission Control Protocol/International Electrotechnical Commission 870-5-101).

### 3) Encryption algorithms used by the industrial system

For example, unencrypted; for another example, VPN-SSL tunneling (Virtual Private Network-Secure Sockets Layer Tunneling).

### 4) Loads of the industrial system

For example, the number of devices comprised in the industrial system, the number of data points in each device, and the message processing rate (update rate and/or polling rate) of each device.

Optionally, in addition to the above parameters of a simulated industrial system, the configuration module 203 may also configure cloud resources for running the simulated industrial system, for example, the provider of the cloud resources, the location of the cloud resources, the processor, memory capacity and the hard disk. For example: Amazon Web Services (AWS) is configured as the provider of the cloud resources, and the location of the cloud resources is configured as Frankfurt, Dublin, Singapore, USA or the like. For another example, a private cloud is configured to provide cloud resources for the industrial system, and the location of the cloud resources is configured as Munich, India or the like.

If the industrial system is a simulated industrial system, then the configuration module 203 is also used for running the configured simulated industrial system. If the configuration module 203 also configures cloud resources for running the industrial system, then the configuration module 203 is specifically used for running the simulated industrial system on the configured cloud resources.

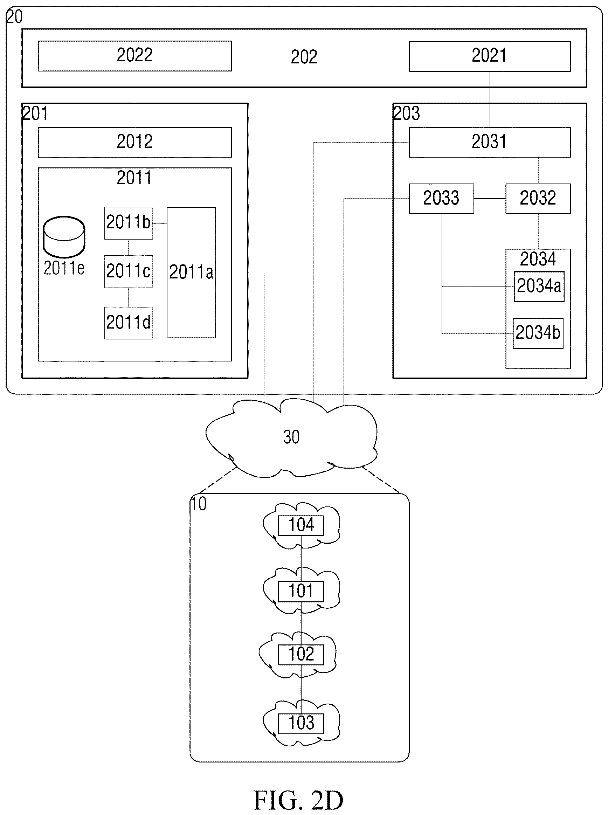

With reference to FIG. 2D, an implementation manner of the performance testing apparatus 20 provided by the embodiments of the present invention when a simulated industrial system is tested is described below.

As shown in FIG. 2D, the performance testing apparatus 20 comprises the following modules:
1) User Interface Module 202
2) Configuration Module 203
3) Performance Testing Module 201

The above modules are described in detail below:

### 1) User Interface Module 202

As shown in FIG. 2D, the performance testing apparatus 20 receives user configuration of a simulated industrial system through a configuration interface 2021 in the user interface module 202, and optionally, may receive user configuration of cloud resources for running the simulated industrial system through the configuration interface 2021. The user may configure the scenarios, communication protocols, security algorithms, device information, and the like of the industrial system as described above through the configuration interface 2021, and may also configure cloud resources for running the simulated industrial system. Besides, the adopted measurement items may also be configured through the configuration interface 2021.

One possible case is that if an existing industrial system is to be deployed onto the cloud, the user may configure the industrial system through the configuration interface 2021 according to the actual conditions of the industrial system, and configure the cloud resources according to the conditions of the cloud onto which the industrial system is to be deployed. In this way, the performance test results can accurately reflect the performance of the industrial system after actually deployed onto the cloud. The user may also adjust the actual configuration of the cloud resources according to the performance test results, then re-test, obtain different test results under different cloud resource configurations, and determine the optimal configuration of the cloud resources by comparing the test results, thereby providing references for the deployment of the industrial system on the cloud afterwards.

Optionally, the performance testing apparatus 20 may also display the performance of the simulated industrial system to the user through a result display interface 2022 in the user interface module 202, and the result display interface 2022 can implement output and visualization of the test results.

### 2) Configuration Module 203

The configuration module 203 is positioned between the user interface module 202 and the cloud 30, and implements the following functions:
configure a simulated industrial system, such as the SCADA system 10 in FIG. 2D;
configure cloud resources; and
deploy the simulated industrial system on the cloud.

A cloud service management module 2032 is the core component of the configuration module 203, and can implement the following functions:
A) provide a programming interface to the user interface module 202 through the program interface module 2031 so as to implement user configuration of the industrial system, and optionally may also used for implementing user configuration of cloud resources; wherein the program interface module 2031 may also receive state information deployed by the industrial system from the cloud 30 and feed the state information back to the user through the user interface module 202;
B) store the following two types of information through the database 2034:
   a mirror image file 2034b, for example, a mirror image of Docker or a virtual machine (VM)
   a configuration file 2034a, wherein the user configures parameters of the industrial system and information of cloud resources for running the industrial system through the user interface module 202, and the cloud service management module 2032 acquires the information through the program interface module 2031, generates the configuration file 2034a and stores the configuration file 2034a in the database 2034; and
C) request cloud resources from the cloud 30 through the open library 2033, deploy the industrial system in the cloud 30, configure the deployed industrial system and release the cloud resources when the industrial system finishes running.

The running of a simulated industrial system on the cloud 30 is implemented through the configuration of the industrial system by the configuration module 203, the deployment on the cloud and the running of the industrial system. In the drawing, some or all of the SCADA server 101, the RTU 102, the field device 103, and the HMI 104 can be deployed and run on the cloud 30.

### 3) Performance Testing Module 201

The performance testing module 201 may acquire logs of various devices in the industrial system running on the cloud 30, acquire data required by generating measurement items and generate the measurement items, wherein the measurement module 2011 may be used for acquiring logs and generating measurement items, and the performance determination module 2012 may be used for determining the performance of the industrial system.

A monitoring module 2011a in the measurement module 2011 may control logs required by generating measurement items by various devices in the industrial system in the cloud 30, and on the other hand, collect the logs from the cloud 30. The collected logs are sent to a log shipping module 2011b.

The log shipping module 2011b outputs the received logs from various devices in the cloud to a log integration module 2011c.

The log shipping module 2011b caches the log stream by using a message queue, filters out useful information from the log, performs calculations and correlations based on a preset rule, and outputs the result to the measurement item generation module 201 Id.

The output of the measurement item generation module 2011d may be stored in a distributed, highly available search engine, namely a lookup and storage module 201 1e.

The performance determination module 2012 performs analysis processing on measurement item information stored in the lookup and storage module and determines the performance of the industrial system. Optionally, a visual program interface may also be provided, so that the result display interface 2022 visually displays the test results to the user.

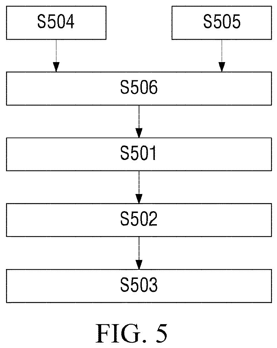

Based on the same inventive concept, the embodiments of the present invention further provides a performance testing method, which can be executed by the forementioned performance testing apparatus 20 to perform performance testing on an industrial system. FIG. 5 is a flow chart of a performance testing method provided by the embodiments of the present invention. As shown in FIG. 5, the method may comprise the following steps:
S501: Monitor various measurement items of an industrial system, such as an end-to-end delay on a processing path mentioned above, network throughput, a network delay, processor usage, memory usage and the like.
S502: According to the measurement items obtained by monitoring, determine the performance of the industrial system, and generate measurement results.
S503: Display the measurement results to the user, for example, display the test results to the user through the forementioned Web UI.

If the industrial system is a simulated industrial system, then before step S501, the method may further comprise the following steps:
S504: Configure the industrial system, such as scenarios of the industrial system, communication protocols and security algorithms used by the industrial system, loads of the industrial system and the like.
S505: Configure cloud resources for running the industrial system, such as the provider of the cloud resources, the location of the cloud resources and the like.
S506: Run the industrial system on the configured cloud resources.

For other optional implementation manners of the method, reference may be made to the implementation of the foregoing performance testing apparatus 20, and details are not described herein again.

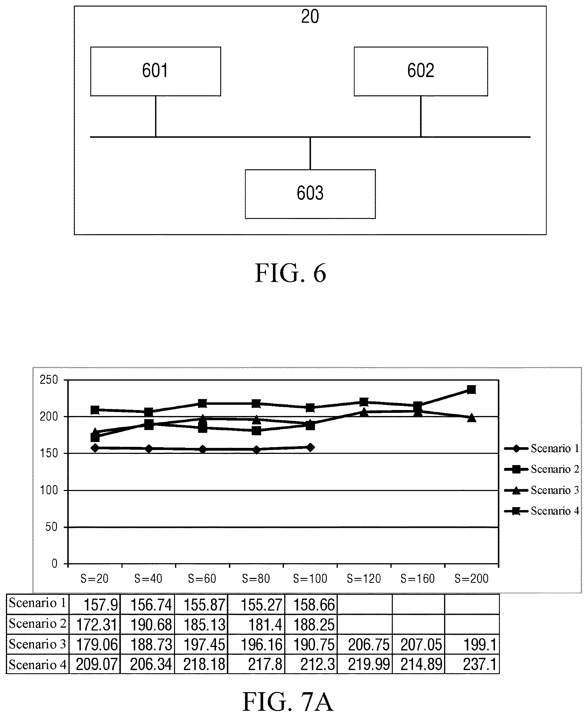

FIG. 6 is a structure diagram of another performance testing apparatus provided by the embodiments of the present invention. Various modules in the performance testing apparatus 20 shown in FIG. 2A to FIG. 2D may be implemented by using a software program. The performance testing apparatus 20 shown in FIG. 6 may be regarded as a hardware implementation manner of the apparatus shown in FIG. 2A to FIG. 2D, wherein the at least one memory 601 is used for storing computer readable instructions, and these computer readable instructions may be distributed in various program modules in FIG. 2A to FIG. 2D; and besides, the at least one memory 601 may also be used for storing files and data, such as the forementioned configuration file 2034a and mirror image file 2034b, generated in the whole testing process. The at least one processor 602 is used for calling the computer readable instructions to execute the testing method shown in FIG. 5 so as to implement various functions implemented by the above performance testing apparatus 20, such as configuration of the industrial system, configuration of the cloud resources, running of the industrial system, acquisition of the test items, determination of the test results, display of the test results and the like. Optionally, the device may further comprise a touch screen 603 used for displaying the test results to the user and receiving the operations of the user, such as configuration of the industrial system, configuration of the cloud resources and the like.

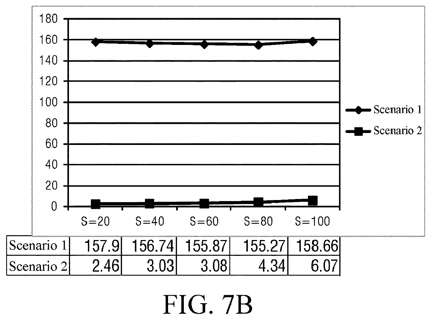

FIG. 7A and FIG. 7B are test results of an end-to-end delay obtained by performing performance testing on a simulated industrial system by using the embodiments of the present invention. The polling rate is: polling cycle=250ms. In the drawings, S represents the processing load, i.e. the number of simulated devices, wherein the processing is performed for each device 16 times per second. In the drawings, the vertical axis represents the end-to-end delay in ms.

FIG. 7A shows the test results of the end-to-end delay of Scenario 1: plant industrial system, Scenario 2: central industrial system, Scenario 3: distributed industrial system and Scenario 4: hierarchical industrial system. It can be seen that the end-to-end delay of the hierarchical industrial system is the largest, the end-to-end delay of the plant industrial system is the smallest, and the change of the end-to-end delay is not obvious under the condition that the load increases in each scenario.

FIG. 7B shows the test results of the end-to-end delay of Scenario 1: plant industrial system (using the Modbus TCP communication protocol) and Scenario 2: plant industrial system (using the IEC 870-5-101 communication protocol). It can be seen that the end-to-end delay of the industrial system in Scenario 2 is much smaller than that of Scenario 1. In Scenario 1, the end-to-end delay comprises the length of time for waiting for a previous poll request and returning a poll response during polling specified by the Modbus TCP protocol.

Based on the same inventive concept, the embodiments of the present invention further provide a computer readable medium in which machine readable instructions for enabling a machine to perform the method as described herein above are stored. Specifically, a system or apparatus equipped with the computer readable medium, in which software program codes for implementing functions of any one of the above embodiments are stored, may be provided, and a computer (or central processing unit (CPU)) or micro processor unit (MPU) of the system or apparatus reads and executes the program codes stored in the storage medium.

In this case, the program codes per se read from the storage medium may implement the functions of any one of the above embodiments, and therefore, the program codes and the storage medium storing the program codes constitute a part of the embodiments of the present invention.

The storage medium embodiments for providing program codes comprise a floppy disk, a hard disk, a magneto-optical disk, an optical disk (such as a compact disc read-only memory (CD-ROM), a compact disk-recordable (CD-R), a compact disk-rewritable (CD-RW), a digital video disc-read only memory (DVD-ROM), a digital versatile disc-random access memory (DVD-RAM), a digital versatile disc±rewritable (DVD±RW), etc.), a magnetic tape, a non-volatile memory card, and a read-only memory (ROM). Optionally, the program codes may be downloaded from a server computer or cloud through a communication network.

In addition, it should be clear that the read program code may be executed by a computer and an operating system operating on the computer may be used based on the instructions of the program codes to complete some or all of actual operations, thereby implementing the functions of any one of the above embodiments.

In addition, it can be understood that the program code read out by the storage medium is written into the memory arranged in an expansion board inserted into the computer or written into the memory arranged in an expansion unit connected with the computer, and a CPU or the like installed on the expansion board or expansion unit executes some or all of actual operations based on the instruction of the program code, thereby implementing the functions of any one of the above embodiments.

In summary, the embodiments of the present invention provide a testing method and apparatus and a storage medium for an industrial system to test the overall performance of the industrial system. By acquiring measurement items, such as the end-to-end delay, accurate performance test results can be provided.

If the embodiments of the present invention are used for testing a simulated industrial system, different test cases may be designed according to actual testing needs, such as the scenario and load of the industrial system, to implement flexible performance testing. The simulated industrial system is close to a real industrial system, so that the system performance can be known in advance before the industrial system is actually deployed. In addition, the test results can also provide references in the aspect of load setting of the industrial system, configuration of the cloud resources and the like.

It should be noted that not all the steps and modules in the procedures and the device structure diagrams above are required, and certain steps or modules may be omitted according to actual needs. The execution sequence of all the steps is not fixed and can be adjusted according to needs. The device structures described in the foregoing embodiments may be physical structures or logical structures, i.e., some modules may be implemented by the same physical entity, or some modules may be implemented by multiple physical entities, or may be implemented jointly by some components in multiple independent devices.

In the above embodiments, a hardware unit may be implemented in a mechanical or electrical manner. For example, a hardware unit may comprise permanently dedicated circuit or logic (such as a dedicated processor, FPGA, or ASIC) to perform the corresponding operations. The hardware unit may also comprise a programmable logic or circuit (such as a general-purpose processor or other programmable processor), and may be temporarily set by software to perform the corresponding operations. The specific implementation manner (mechanical manner, or dedicated permanent circuit, or temporarily arranged circuits) may be determined based on considerations on cost and time.

The present invention has been illustrated and described in detail with reference to the accompanying drawings and preferred embodiments. However, the present invention is not limited to these disclosed embodiments. Based on the above-mentioned multiple embodiments, those skilled in the art should understand that more embodiments of the present invention may be obtained by combining code review means in the above different embodiments, and these embodiments also fall within the protection scope of the present invention.

## Claims

1. A performance testing method, used for performing performance testing on an industrial system deployed on a cloud, wherein the method comprises:
acquiring a device processing delay of each device in at least two devices on an end-to-end processing path in the industrial system and a data transmission delay between any two adjacent devices in the at least two devices; and
determining an end-to-end delay on the processing path according to the device processing delay and the data transmission delay acquired to measure the performance of the industrial system.

2. The method of claim 1, wherein the method further comprises:
determining an end-to-end delay on at least one other processing path in the industrial system; and
comparing the acquired end-to-end delays on the various processing paths to determine a device and/or transmission line affecting the performance of the industrial system.

3. The method of claim 1 or 2, wherein the industrial system is a simulated industrial system, and before acquiring the device processing delay of each device in at least two devices on an end-to-end processing path in the industrial system and the data transmission delay between any two adjacent devices in the at least two devices, the method further comprises:
receiving user configuration of the industrial system; and
running the configured industrial system.

4. The method of claim 3, wherein the receiving user configuration of the industrial system comprises: receiving and configuring at least one of the following parameters of the industrial system input by the user:
scenarios of the industrial system;
communication protocols used by the industrial system;
security algorithms used by the industrial system; and
loads of the industrial system.

5. The method of claim 3 or 4, wherein
before the running the simulated industrial system, the method further comprises:
receiving user configuration of cloud resources for running the simulated industrial system; and
the running the configured industrial system comprises: running the industrial system on the configured cloud resources.

6. The method of any one of claims 3 to 5, wherein
the receiving user configuration of the industrial system comprises: receiving the industrial system configured by at least one user through a Web user interface (UI); and/or
displaying performance of the industrial system to the at least one user through the Web UI.

7. A performance testing method, used for performing performance testing on an industrial system deployed on a cloud, wherein the industrial system is a simulated industrial system, and the method comprises:
receiving and configuring at least one of the following parameters of the industrial system input by a user:
scenarios of the industrial system;
communication protocols used by the industrial system;
security algorithms used by the industrial system; and
loads of the industrial system;
running the configured industrial system; and
performing performance testing on the industrial system.

8. The method of claim 7, wherein
before running the industrial system, the method further comprises: receiving user configuration of cloud resources for running the industrial system; and
the running the configured industrial system comprises: running the industrial system on the configured cloud resources.

9. The method of claim 7 or 8, wherein the performing performance testing on the industrial system comprises:
acquiring a device processing delay of each device in at least two devices on an end-to-end processing path in the industrial system and a data transmission delay between any two adjacent devices in the at least two devices; and
determining an end-to-end delay on the processing path according to the device processing delay and the data transmission delay acquired to measure the performance of the industrial system.

10. The method of claim 9, wherein
the performing performance testing on the industrial system further comprises:
determining an end-to-end delay on at least one other processing path in the industrial system; and
the method further comprises: comparing the acquired end-to-end delays on the various processing paths to determine a device and/or transmission line affecting the performance of the industrial system.

11. A performance testing apparatus (20), used for performing performance testing on an industrial system deployed on a cloud, wherein the apparatus (20) comprises:
a measurement module (2011), used for acquiring a device processing delay of each device in at least two devices on an end-to-end processing path in the industrial system and a data transmission delay between any two adjacent devices in the at least two devices; and
a performance determination module (2012), used for determining an end-to-end delay on the processing path according to the device processing delay and the data transmission delay acquired by the measurement module (2011) to measure the performance of the industrial system.

12. A performance testing apparatus (20), used for performing performance testing on an industrial system deployed on a cloud, wherein the industrial system is a simulated industrial system, and the apparatus (20) comprises:
a configuration module (203), used for receiving and configuring at least one of the following parameters of the industrial system input by a user:
scenarios of the industrial system;
communication protocols used by the industrial system;
encryption algorithms used by the industrial system; and
loads of the industrial system;
wherein the configuration module (203) is also used for running the configured industrial system on the cloud; and
a performance testing module (201), used for performing performance testing on the industrial system.

13. A performance testing apparatus, wherein the apparatus comprises:
at least one memory (601), used for storing a computer readable instruction; and
at least one processor (602), used for calling the computer readable instruction to execute the method of any one of claims 1 to 10.

14. A computer readable medium, wherein the computer readable medium stores a computer readable instruction, and the machine readable instruction, when being executed by at least one processor, enables the at least one processor to execute the method of any one of claims 1 to 10.
